# EUROPEAN PATENT APPLICATION

(11) **EP 2 811 366 A1**
(43) Date of publication of application: **10.12.2014**
(21) Application number: 13837834.4
(22) Date of filing: 13.09.2013
(51) Int. Cl.: G06F 1/20, H05K 7/20

(54) **AIR CONDITIONING SYSTEM**

(30) Priority: 14.09.2012 JP 2012203230
(71) Applicant: GAC Corporation, Nagano 399-8286 (JP)
(72) Inventor: OKI, Junichi, Azumino-shi Nagano 399-8286 (JP); YAMAGUCHI, Shoichi, Azumino-shi Nagano 399-8286 (JP)
(74) Representative: Körber, Martin Hans
(86) International application number: PCT/JP2013/005452
(87) International publication number: WO 2014/041819

(57) **Abstract**

An air-conditioning system includes: an interior heat exchanging system that partitions a hot area side of a rack row, where a plurality of racks, in which heat generating equipment is held, are aligned in a lateral direction, along the rack row to form a cold air buffer area to the outside of the hot area; a supplying fan that supplies cold air from the cold air buffer area to a cold area side of the rack row via an underfloor side of a double floor on which the rack row has been disposed; and an exterior heat exchanging system, a refrigerant circulating between the exterior heat exchanging system and the interior heat exchanging system via a piping system. It is possible to provide an air-conditioning system with low power consumption suited to air conditioning of a server room.

## Description

### BACKGROUND

The present invention relates to a system that carries out air conditioning of racks in which heat generating equipment, such as servers, is held.

The server room unit disclosed in Japanese Laid-Open Patent Publication No. 2012-098799 is equipped with a plurality of server racks and cooling equipment inside a casing that can be disposed adjacent to other such casings and can function as a server room. Such server room unit separately forms a cold area and a hot area inside the casing, and has server racks aligned in a row at the boundary between the cold area and the hot area to enable ventilation of the server racks. In such server room unit, the cooling equipment is constructed of an exhaust fan constructed to supply outside air to the cold area and to discharge air from the hot area to the outside and an air conditioner apparatus constructed to produce cold air and to circulate the cold air inside the casing. At a unit-type data center, a plurality of server room units are disposed adjacent one another inside a building and such server room units construct a server room.

### SUMMARY

By utilizing a cooling device that uses outside air, it is possible to reduce the power consumption of a server room. However, to introduce outside air, a filter is necessary, and it also becomes necessary to frequently replace the filter. This results in an increase in maintenance cost. It is also difficult to maintain a suitable humidity level inside the server room regardless of the outside weather and/or season.

Accordingly, there is demand for a system that is suited to air conditioning a server room or the like, has a low maintenance cost, and is largely unaffected by outside air.

One aspect of the present invention is an air-conditioning system including: an interior heat exchanging system that partitions a hot area side of a rack row, where a plurality of racks, in which heat generating equipment is held, are aligned in a lateral direction, along the rack row to form a cold air buffer area to the outside of the hot area; a supplying fan that supplies cold air from the cold air buffer area to a cold area side of the rack row via an underfloor side of a double floor on which the rack row has been disposed; and an exterior heat exchanging system. A refrigerant circulates between the exterior heat exchanging system and the interior heat exchanging system via a piping system.

This air-conditioning system makes use of the state whereby the heat load is concentrated on the hot area side of the racks. By partitioning the hot area by disposing the interior heat exchanging system in parallel with the rack row on the hot area side of the rack row, a cold air buffer area is formed outside the hot area. Also a hot spot is formed by the interior heat exchanging system in the hot area that is as a more limited region within the hot area in the room. Since the temperature of the interior air introduced into the interior heat exchanging system from the area of the hot spot in the hot area is kept at a high temperature, it is possible to maintain a temperature difference between the interior air to be cooled and the outside air. This means that it is possible to increase the cooling efficiency of the air conditioning system and to reduce the power consumption of the air conditioning system.

Also with this air-conditioning system, a cold air buffer area is formed by the interior heat exchanging system that extends along the rack row and the cold air of such cold air buffer area is supplied via the underfloor area to the cold area side of the rack row. Accordingly, when the cooling load along the rack row differs between positions due to differences in output or in operating state of the heat generating equipment held in the rack row and/or due to differences in the peripheral environment of the rack row, it is possible to reduce the power consumption of the air-conditioning system by making the performance of the interior heat exchanging system variable along the rack row.

It is effective for this air-conditioning system to be a natural circulation type. That is, it is desirable for the exterior heat transfer system to include a natural circulation exterior heat transfer system that carries out natural circulation of refrigerant to and from the interior heat exchanging system via a piping system. By using a natural circulation type, it is possible to cool the interior without introducing outside air into the interior and without using a compressor. This means that it is possible to realize an air-conditioning system that can further reduce power consumption, has a low maintenance cost, and is little affected by outside air. By forming the cold air buffer area by partitioning the hot area using the interior heat exchanging system, it is possible to maintain a temperature difference between the interior air at the hot spots to be cooled and the outside air. This means that it is possible to cool the interior using natural circulation even in a state where the outside air temperature is higher.

In this air-conditioning system, it is desirable for the interior heat exchanging system to include a plurality of interior units disposed in a line in the lateral direction, and for the exterior heat exchanging system to include a plurality of exterior units that are connected to respective units out of the plurality of interior units via separate or independent piping systems. When the cooling load of the interior units and the exterior units has changed due to the heat load for each rack or for each area of the rack row, it is possible to separately control the power consumption of the outside air fans provided corresponding to the exterior units and to further reduce the power consumption of the air-conditioning system. By connecting the interior units and the exterior units using separate piping, it is possible to have refrigerant circulate naturally according to the conditions of the combined interior units and exterior units, and to achieve the greatest possible cooling performance through natural circulation. It is desirable for the plurality of interior units to be disposed corresponding to respective racks out of the plurality of racks aligned in the width or lateral direction.

It is also desirable for the supplying fan to include a plurality of fan units disposed corresponding to the plurality of interior units. The fan units are typically disposed in rack units. By individually controlling the fan units, it is possible to further reduce the power consumption.

It is desirable for the air-conditioning system to include a plurality of partition members which partition the hot area at positions respectively corresponding to the plurality of racks that are aligned in the lateral direction and which obstruct the dispersion of hot air in the hot area. One example of the partition members is flameproof curtains that are unlikely to obstruct maintenance. By partitioning the hot area in rack units, it is possible to drive the air-conditioning system with cooling loads corresponding to the heat loads in rack units aligned in the lateral direction. This means that it is easy to reduce the power consumption of the air-conditioning system.

In this air-conditioning system, it is also desirable for the interior units to include a plurality of interior sub units disposed in the up-down direction, and for the exterior units to include a plurality of exterior sub units connected to respective units out of the plurality of interior sub units via separate or independent piping systems. Since the cooling load of the interior sub units and the exterior sub units are changeable corresponding to fluctuations in the heat load in the up-down direction of the racks, it is possible to further reduce power consumption. When the racks aligned in the lateral direction can also stack in the vertical direction (up-down direction), it is possible to cope with differences in heat output of heat generating equipment held in the up-down direction in the racks. In addition, by connecting with separate piping systems, it is possible to realize cooling according to natural circulation with a combination of sub units.

That is, the interior heat exchanging system of such air-conditioning system includes a plurality of interior sub units disposed horizontally and vertically (up-down and left-right) in a matrix in parallel with the rack row, with such interior sub units being connected by separate piping systems to the exterior sub units. Accordingly, by combining the interior sub units and the exterior sub units, refrigerant will naturally circulate if conditions of the respective combinations (pairs of sub units) are satisfied, thereby achieving a cooling performance using natural circulation. Even if the plurality of interior sub units disposed in a matrix are not actively controlled individually (although such control is also possible), if the heat load to be removed by an individual interior sub unit becomes high, natural circulation of refrigerant will start automatically (autonomously) and by discharging heat to the exterior sub unit in this way, it is possible to discharge waste heat of heat-generating equipment held in a rack to the outside. The matrix of the interior sub units may correspond to the racks (levels, shelves) in the vertical and horizontal direction (up-down and left-right) of the rack row.

It is also effective for the supplying fan to include a plurality of fan units that blow out cold air toward different positions in the up-down direction of the racks. It is possible to selectively supply cold air to positions in the up-down direction of a rack where the heat load (heat output) is high.

The interior heat exchanging system may be disposed so as to be inclined to form a cold air buffer area that is narrow at the top and wide at the bottom. It is possible to improve the cooling efficiency by widening the area that contacts the hot area side and in addition it is easy to achieve a balanced air flow in the up-down direction inside the cold air buffer area.

Another aspect of the present invention is a room unit including the air-conditioning system described above, a rack row where a plurality of racks are aligned in the lateral direction, a double floor on which the rack row is installed, and a housing that stores the rack row and the interior heat exchanging system of the air-conditioning system. A typical example of the heat-generating equipment held in the racks is servers. The plurality of racks may include server racks where servers are held in the up-down direction. A typical example of a room unit is a server room unit.

### BRIEF DESCRIPTION OF THE DRAWINGS

FIG. 1 is a vertical cross-sectional view showing the layout of a server room;
FIG. 2 is a horizontal cross-sectional view showing the layout of a server room; and
FIG. 3 is a vertical cross-sectional view showing the layout of a different server room.

### DETAILED DESCRIPTION

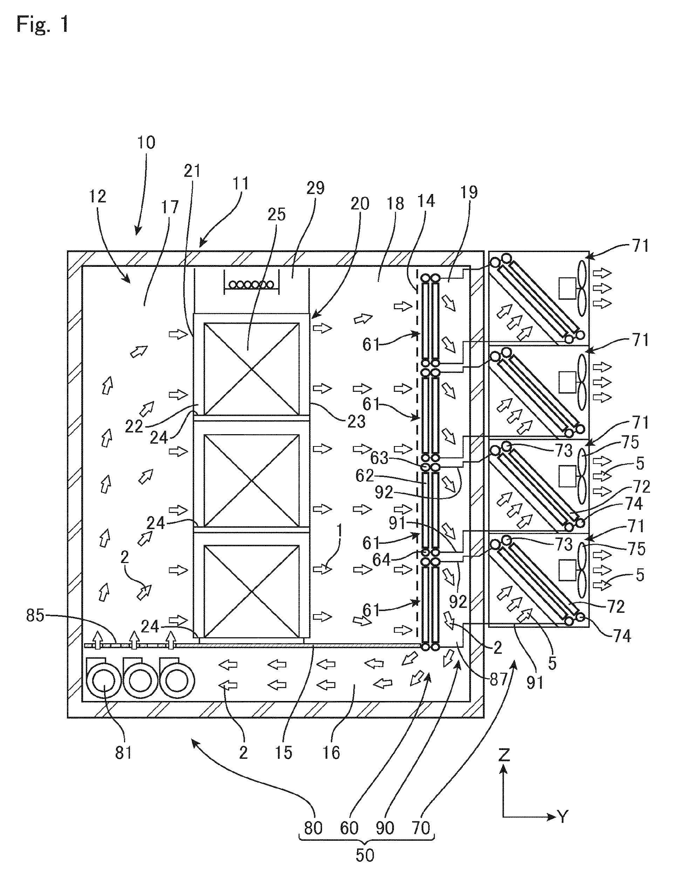

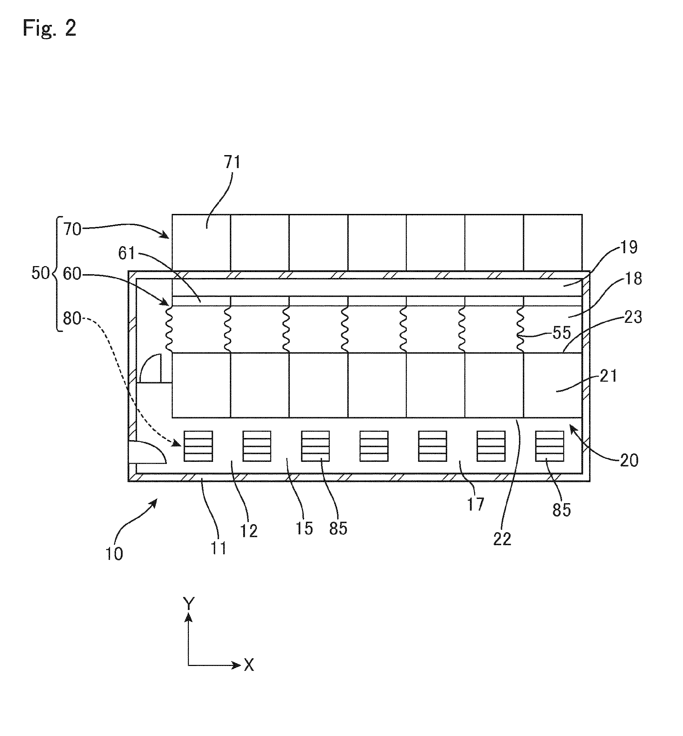

FIG. 1 shows the overall layout of a container-type server room by way of a cross-sectional view in the vertical direction (perpendicular direction), while FIG. 2 shows the layout by way of a cross-sectional view in the horizontal direction (horizontal cross-sectional view). The server room (server room unit) 10 is a container-type room in the overall form of a rectangular solid that extends in the width or lateral direction (X direction), and includes a housing 11 that surrounds a server room 10, a rack row 20 disposed in the center of the interior 12 of the server room 10, a double floor 15 on which the rack row 20 is installed, and a rack air-conditioning system (air-conditioning system) 50 that cools the interior 12 of the server room 10. The rack row 20 includes a plurality of racks (storage shelves, placement shelves, server racks) 21 which respectively store servers 25 in the present embodiment, and a cable wiring space provided above the racks 21.

The plurality of racks 21 are aligned, in the lateral direction (horizontal direction, X direction), in a line in the length direction of the server room 10, with adjacent racks 21 being connected. The individual racks 21 have a multilevel structure so that a plurality of servers 25 can be held on multiple levels. The racks 21 may have a three-level structure and include three shelves (levels) in the up-down direction. The individual servers 25 stored in the racks are equipped with fans for cooling the inside, and draw in and exhaust air in a front-rear direction (Y direction) that is perpendicular to the length direction of the rack row 20. In the following description it is assumed that the drawing direction of a server 25 is the front side 22 of the servers 25 and the racks 21 and the exhaust direction is the rear side 23 of the servers 25 and the racks 21. Accordingly, the front side 22 of the racks 21 is a cold area (cold aisle) 17 and the rear side 23 is a hot area (hot aisle) 18.

The air-conditioning system 50 includes an interior heat exchanging system (interior heat exchanger, indoor heat exchanging apparatus) 60, an exterior heat exchanging system (exterior heat exchanger, outdoor heat exchanging apparatus) 70, a cold air supplying fan 80, and a piping system 90 that circulates refrigerant (coolant) between the interior heat exchanging system 60 and the exterior heat exchanging system 70. The interior heat exchanging system 60 includes a plurality of interior heat exchanger units (interior units) 61, with such interior units 61 being disposed so as to partition, along the rack row 20, the hot area 18 side on the rear side 23 of the rack row 20 and thereby form a cold air buffer area 19 to the outside of the hot area 18.

The plurality of interior units 61 are disposed so as to form a matrix in the up-down and left-right directions (i.e., vertically and horizontally) and form a wall that is parallel with the rack row 20 and functions as a partition to separate the hot area 18 and the cold air buffer area 19. In this example, a support frame or support wall 14 which is made of a porous plate member, such as punching metal or expansion metal, and enables air to pass through is formed behind (i.e., on the rear side) 23 of the rack row 20 at a position that is separated from the racks 21 by around the same distance as the width (depth) of the respective racks 21. The plurality of interior units 61 are attached to the support wall 14, and form a partition that separates the hot area 18 and the cold air buffer area 19.

The supplying fan 80 includes a plurality of fan units 81. The fan units 81 are disposed in the underfloor area 16 so as to supply cold air 2 in the cold air buffer area 19 via the underfloor area 16 of the double floor 15 to the cold area 17 in front of (at the front side of) 22 the rack row 20. That is, the bottom end of the cold air buffer area 19 of the floor 15 is an opening 87 so that the cold air 2 in the cold air buffer area 19 forms a down flow and is discharged to the underfloor area 16. A louver 85 that enables cold air 2 to be blown out to the cold area 17 is provided on the cold area 17 side of the floor 15 so that the cold air 2 is supplied to the cold area 17 by the supplying fan 80.

A system that circulates the cold air 2 via the double floor 15 has a number of merits. First, by using the double floor 15 as a duct, it is possible to supply an economical air-conditioning system 50 in a small space. Even if condensation occurs for the cold air 2, it is possible to cause evaporation inside the double floor 15 and also to prevent condensation from leaking from a ceiling or the like and affecting the servers. In addition, with this system 50, it is possible to connect the cold air buffer area 19 formed outside the hot area 18 and the cold area 17 with the shortest possible route and possible to use the double floor 15 as a buffer region for the cold air 2. This means that it is possible to suppress fluctuations in the temperature of the cold air 2 even if there are localized increases in the exhaust air temperature and localized fluctuations in the heat load of the interior heat exchanging system 60.

The exterior heat exchanging system 70 includes a plurality of exterior heat exchanger units (exterior units) 71, and the plurality of exterior units 71 are disposed to the outside of the housing 11.

The plurality of interior units 61 are disposed in the lateral direction (X direction, horizontal direction) so as to face the rear 23 of the respective racks 21 and are disposed on four levels in the vertical direction (Z direction, perpendicular direction). The respective interior units 61 include a heat-transfer surface 62 where a plurality of tubes are disposed so as to extend in the up-down direction, an upper header 63 that is connected to the upper ends of the plurality of tubes, and a lower header 64 that is connected to the lower ends of the plurality of tubes.

The plurality of exterior units 71 are stacked on levels at appropriate height positions outside the side wall of the housing 11 with a space in between to allow outside air 5 to pass. The respective exterior units 71 include a heat-transfer surface 72 where a plurality of tubes are disposed so as to extend in the up-down direction, an upper header 73 that is connected to the upper ends of the plurality of tubes, a lower header 74 that is connected to the lower ends of the plurality of tubes, and an outside air fan 75 that supplies the outside air 5 to the heat-transfer surface 72.

The piping system 90 includes liquid refrigerant pipes 91 that connect the lower headers 74 of the respective exterior units 71 and the lower headers 64 of the respective interior units 61 and gas refrigerant pipes 92 that connect the upper headers 63 of the respective interior units 61 and the upper headers 73 of the respective exterior units 71. The respective units out of the plurality of interior units 61 are connected to one or a plurality of exterior units 71 that correspond on a one-to-one basis to the respective interior units 61 by the independent piping system 90 so that the interior units 61 and the exterior units 71 that are connected by the independent piping system 90 operate in pairs.

The respective exterior units 71 are disposed at positions that are higher than the corresponding interior units 61 that are connected by the pipes 91 and 92. This means that refrigerant that has exchanged heat with the outside air 5 and has liquefied at the exterior units 71 is supplied by gravity and the internal pressure difference via the liquid refrigerant pipes 91 to the interior units 61. The gas refrigerant that has been gasified in the interior units 61 due to the interior heat load is supplied via the gas refrigerant pipes 92 using the difference in specific gravity and is liquefied using the outside air 5.

Accordingly, in the air-conditioning system 50, the refrigerant naturally circulates between the interior units 61 and the exterior units 71 that are separately connected by the piping system 90 to form pairs. This means that a compressor is unnecessary and it is possible to omit the power required to run a compressor. Also, if the heat load (radiant heat load) of the exterior units 71 is small and/or if the wind speed is sufficient, by lowering the speed or stopping the outside air fan 75, it is possible to also omit the power necessary to run the outside air fan 75. Accordingly, it is possible to indirectly cool the interior 12 by the outside air via a refrigerant with low power consumption, or without consuming power depending on the outside air conditions, and without introducing outside air.

The air (cold air) 2 cooled by the interior units 61 falls through the cold air buffer area 19 separated by the interior units 61, passes through the space 16 in the underfloor area, and is discharged to the cold area (cold aisle) 17 at the front 22 of the rack row 20 and the servers 25 by the supplying fan 80. The supplying fan 80 includes the plurality of fan units 81 whose installation positions and/or blowing directions (up-down and left-right) are adjusted so as to supply the cold air 2 to the respective servers 25 that are stacked on levels in the up-down direction. The cold air 2 blown out to the cold area 17 is drawn in by the fans incorporated in the servers 25, picks up the heat inside the servers 25, and is discharged to the hot area (hot aisle) 18 at the rear 23 of the rack row 20 as the warm (hot) exhaust air 1. The high-temperature exhaust air 1 in the hot area 18 is cooled by the interior units 61 disposed in the form of a partition at the rear 23 of the rack row 20 and is discharged to the cold air buffer area (buffer aisle) 19 as the cold air 2.

In the air-conditioning system 50, the servers 25 held in the rack row 20 are cooled by circulating the air in the interior (room) 12. Accordingly, it is unnecessary to introduce outside air and it is therefore possible to omit a filter required when introducing outside air. Also, since it is unnecessary to introduce outside air, it is also unnecessary to adjust the humidity depending on the weather, season, or the like. In addition, the air-conditioning system 50 operates according to natural circulation of refrigerant. This means that if the outside air temperature is lower than the air temperature of the interior 12 to be cooled, the inside of the server room 10 is cooled with low power consumption. Further, depending on the conditions, the inside of the server room 10 is cooled in a state where power is not consumed.

In the air-conditioning system 50, the plurality of interior units 61 are aligned substantially in parallel to the rack row 20 to form a partition in the hot area 18 and hot spots are deliberately formed between the rack row 20 and the interior units 61. By using this configuration, it is possible to avoid a situation where the exhaust air 1 of the server 25 spreads out to other parts of the interior 12 so that the entire interior 12 would reach a high temperature, and to keep the temperature of the exhaust air 1 that is to be cooled by the interior units 61 at close to the exhaust temperature of the servers 25, that is, at a high temperature. This means that it is possible to keep the temperature of the air (exhaust air) 1 that is to be cooled by the interior units 61 at a high temperature, to maintain a temperature difference with the outside air 5, and to cool the interior 12 using the natural circulation-type air-conditioning system 50 even in conditions, such as during summer, where the temperature of the outside air 5 is high. As one example, if the operating temperature limit of the heat-generating equipment held in the rack 21 is around 40°C, it is possible to remove the heat load of the interior 12 using the natural circulation-type air-conditioning system 50 with low power consumption up to an outside air temperature of around 35°C and to keep the temperature of the interior 12 at predetermined conditions.

In recent years, servers 25 compatible with a 40°C environment have come on sale and for a server room 10 that houses servers 25 with such high operating temperature limit, it is possible to keep the temperature of the interior 12 within the predetermined operating conditions, even during summer, using only a natural circulation-type air-conditioning system 50. In regions where the outside temperature exceeds 35°C in summer, it is possible to provide an air-conditioning system that uses a compressor as an auxiliary system.

As shown in FIG. 2 the air-conditioning system 50 includes flameproof curtains 55 that partition the hot area 18 into the units as rack 21 units. The flameproof curtains 55 extend from the top to the bottom of the hot area 18 and function as partition members that partition the hot area 18 at positions corresponding to the respective racks out of the plurality of racks 21 to prevent dispersion or flows of the hot air. Accordingly, the flameproof curtains 55 are capable of preventing a situation where high-temperature exhaust air 1 discharged to the hot area 18 from a server 25 that is mounted on a given rack (a first rack) 21 and has a high load from becoming dispersed to the hot area 18 of other racks 21.

By using the flameproof curtains 55, it is possible to produce hot spots to the rear 23 of servers 25 with a high load and to maintain a high temperature for the interior air that is to undergo heat exchanging at the interior unit 61 connected to the hot area 18 at such hot spots. Accordingly, it is possible to maintain a difference between the interior temperature in parts of the room and the outside air temperature, so that refrigerant will naturally circulate between the interior units 61 and the exterior units 71 of pairs that are connected by the separate piping system 90 due to the conditions in the parts of the room that face such interior units 61. This means that by using a natural circulation-type air-conditioning system 50 that includes a plurality of pairs of interior units 61 and exterior units 71 that are distributed, it is possible to efficiently discharge the heat load of the exhaust air 1 of the servers 25 to the outside air 5 and to keep the temperature of the interior 12 at a predetermined condition.

Also, the heat load of the interior units 61 connected to the hot area 18 of servers 25 with a high load becomes high and concentrated, which makes it possible to prevent the heat load (cooling load) of interior units 61 in the periphery from also becoming high. The heat load (heat discharge load) of the exterior units 71 corresponding to such interior units 61 also becomes high and concentrated, so that the outside air fans 75 of only exterior units 71 with a high heat load are driven, which makes it possible to reduce the speed of or stop the outside air fans 75 of other exterior units 71 with a low heat load. Accordingly, since it is possible to individually carry out on-off control of the outside air fans 75 according to the heat load, it is possible to also reduce the power consumption of the outside air fans 75.

The partition members that partition the hot area 18 are not limited to the flameproof curtains 55. However, since the hot area 18 at the rear of the servers 25 is a space that is necessary for maintenance such as replacing the servers 25 and connecting cables, it is desirable for such space to be accessed with comparative freedom. Since the flameproof curtains 55 make access possible, impede the dispersion of the exhaust air 1, and can prevent the spread of fire in case of an accident, such flameproof curtains 55 are favorable as a partition member that prevents the dispersion of hot air in the hot area 18.

In this rack air-conditioning system 50, the interior units 61 are disposed so as to be divided in the up-down direction. Accordingly, the heat load of the interior units 61 at positions (heights) that process (cool) the exhaust air 1 of servers 25 with a high load, out of the servers 25 stacked on levels in a rack 21, increases and suppress an increase in the heat load of the interior units 61 at positions (heights) that process (cool) the exhaust air 1 of servers 25 disposed on other levels. At different heights (up-down, Z direction) in the hot area 18, the outside air fans 75 of only exterior units 71 corresponding to interior units 61 with a high heat load are driven and it is possible to stop the outside air fans 75 of other exterior units 71 that have a low heat load. Since it is possible to individually carry out on-off control of the outside air fans 75 according to the heat load, it is possible to also reduce the power consumption of the outside air fans 75.

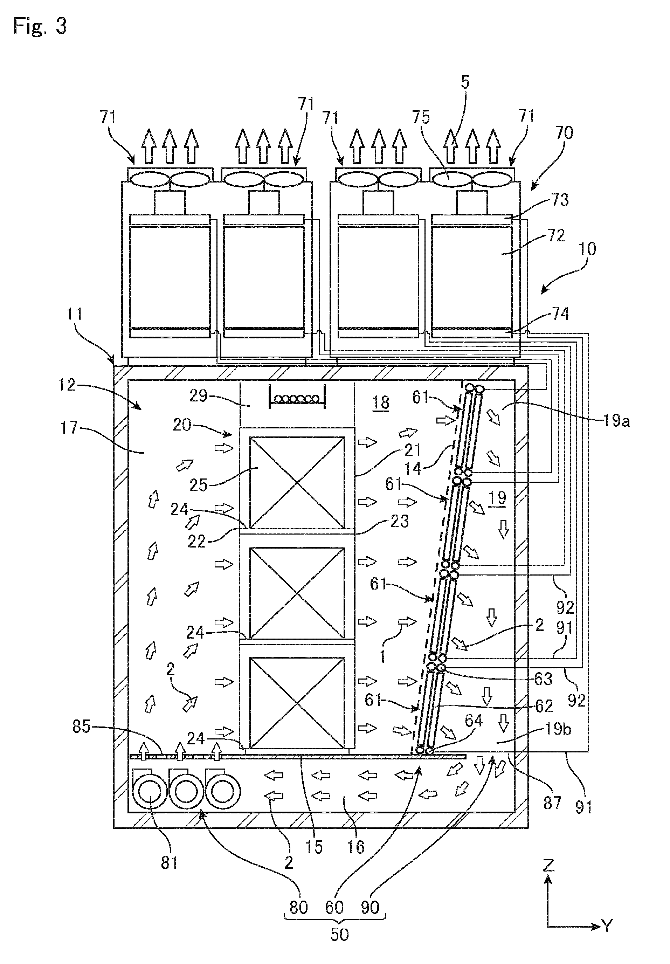

FIG. 3 shows a different example of a container-type server room. This server room 10 also includes a housing 11, a rack row 20 installed in the center of the interior 12 of the server room 10, a double floor 15 that supports the rack row 20, and an air-conditioning system 50 that cools the interior 12 of the server room 10. The air-conditioning system 50 includes an exterior (outdoor) heat exchanging system 70 including an exterior unit (outdoor unit) 71 installed in the ceiling of the housing 11. Also, the plurality of interior units (indoor units) 61 of the interior (indoor) heat exchanging system 60 form a partition that is inclined so as to form a cold air buffer area 19 whose upper end 19a is narrow and the lower end 19b is wide. Accordingly, the interior units 61 are also disposed so as to be inclined. The remaining configuration of the air-conditioning system 50 is the same as the system 50 shown in FIG. 1.

By disposing the interior units 61 so as to be inclined to the perpendicular direction so that the lower end 19b of the cold air buffer area 19 becomes wider, the cross-sectional area passed by the cold air 2 inside the cold air buffer area 19 will gradually increase toward the lower end 19b. Since the interior units 61 are disposed on multiple levels in the up-down direction, the air volume of the cold air 2 that passes the interior units 61 increases toward the lower end 19b. In the server room 10, since the lower end 19b of the cold air buffer area 19 is wider, the cold air 2 will smoothly flow even at the lower end 19b of the cold air buffer area 19, there will be a reduction in the pressure drop, and it will be possible to maintain a sufficient air flow passing through the interior units 61, even for the interior units 61 positioned toward the bottom.

In addition, since the interior units 61 are disposed so as to be inclined with respect to the hot area 18, the area of contact between the interior units 61 and the hot area 18 increases. Since the individual interior units 61 are also inclined so that the cold air 2 is wider at the bottom, the cold air 2 is smoothly discharged to below. Accordingly, it is possible to improve the cooling performance of the respective interior units 61.

In the server room 10 in which the air-conditioning system 50 is installed, the hot area 18 is partitioned by disposing the interior units 61 in the hot area 18 in parallel with the rack row 20, and by preventing the spread of the high-temperature exhaust air 1 discharged to the hot area 18, it is possible to keep the temperature of the exhaust air 1 that is to undergo heat exchanging at the interior units 61 at a high temperature. This means that with the air-conditioning system 50, it is possible to maintain a temperature difference between the temperature of the interior air (exhaust air) 1 subjected to heat exchanging at the interior units 61 and the temperature of the outside air 5. As a result, in addition to the time zones and periods where the outside temperature falls, such as during winter or during the night, it is also possible during time zones and periods where the outside temperature is high, such as during summer or during the day, to remove the heat load of the servers 25 using a natural circulation-type air-conditioning system in a state with low or zero power consumption depending on the conditions.

Also, with the air-conditioning system 50, it is possible to cool the exhaust air 1 of the respective servers 25 using the interior units 61 that are disposed in units of the racks 21. In addition, with the air-conditioning system 50 where the interior units 61 are disposed in a matrix, cooling is carried out by interior units 61 that are laid out not only in the left-right direction but also in level units in the up-down direction. In addition, the interior units 61 and exterior units 71 form pairs, so that it is possible to achieve natural circulation of refrigerant in units of such pairs. Accordingly, it is possible to realize natural circulation-type cooling with low power consumption in units of the interior units 61 that are disposed in a matrix. Also, it is possible to suppress the power consumption of the exterior units 71 connected to interior units 61 with a low heat load and to suppress the power consumption of the air-conditioning system 50 as a whole.

In addition, in the air-conditioning system 50, the exhaust air 1 of individual servers 25 is cooled by the interior units 61 and discharged to a shared cold air buffer area 19 and then recirculated. Accordingly, since it is possible to absorb fluctuations in load between the individual servers 25 using the corresponding interior units 61, it is possible to keep the temperature of the cold area 17 constant, which makes it possible to avoid having temperature affect the performance of other servers 25.

Note that although the examples where the heat generating equipment are the servers 25 has been described above, the appliances mounted in the racks 21 are not limited to the servers 25 and may be power conditioners (PCS) used at a large-scale solar power station, communication/exchange equipment disposed at a mobile telephone base station, or the like. Also, although a container-type server room (server room unit) 10 that can be independently set up has been described above as an example, the server room is not limited to a container type and may be a server room in a data center. The number of rows in which the racks are laid out is not limited to one and there may be two or more rows.

Although a plurality of interior units 61 are disposed in the up-down direction and the exterior units 71 are disposed corresponding to the respective interior units 61 in the example described above, one interior unit 61 may be disposed per rack, or a plurality of racks may be cooled by a shared interior unit 61. Also, the layout of the exterior unit 71 is not limited to the above description and it is also possible to divide a plurality of interior units 61 into a plurality of groups based on the heat load, operation forecasts for the servers 25, or the like and to provide exterior units 71 that are commonly connected to such groups of interior units 61. Although an air-conditioning system where a plurality of interior units 61 operate together is included in the present invention, it is desirable to use a design where a plurality of interior units 61 are divided into appropriate regions and cooling is carried out according to natural circulation.

The outside air fans 75 may be provided corresponding to the individual exterior units 71 or the plurality of exterior units 71 may be divided into appropriate groups and the outside air fans 75 may be provided corresponding to the respective groups. In addition, it is also possible to provide interior fans for the individual interior units 61 or for groups of the interior units 61 to control the flow of air passing through.

In addition, the air-conditioning system described above uses a natural circulation thermo-siphon type system (cooling apparatus) thought to have the lowest possible power consumption as the means of releasing heat generated in the room to the outside. The cooling system according to the present invention is not limited to a natural circulation type. The heat dissipation method is not limited to a thermo-siphon and it is also possible to use a liquid circulating (pumped) system that uses cold water or brine or to use a refrigeration cycle system that uses a compressor.

## Claims

1. An air-conditioning system comprising:
an interior heat exchanging system that partitions a hot area side of a rack row along the rack row to form a cold air buffer area to an outside of the hot area, the rack row containing a plurality of racks aligned in a lateral direction for holding heat generating equipment;
a supplying fan that supplies cold air from the cold air buffer area to a cold area side of the rack row via an underfloor side of a double floor on which the rack row has been disposed; and
an exterior heat exchanging system, a refrigerant circulating between the exterior heat exchanging system and the interior heat exchanging system via a piping system.

2. The air-conditioning system according to claim 1,
wherein the exterior heat exchanging system includes a natural circulation exterior heat exchanging system, the refrigerant naturally circulating between the natural circulation exterior heat exchanging system and the interior heat exchanging system.

3. The air-conditioning system according to claim 1 or 2,
wherein the interior heat exchanging system includes a plurality of interior units disposed in a line in the lateral direction, and
the exterior heat exchanging system includes a plurality of exterior units that are connected to respective units out of the plurality of interior units via separate piping systems.

4. The air-conditioning system according to claim 3,
wherein the supplying fan includes a plurality of fan units disposed so as to correspond to respective units out of the plurality of interior units.

5. The air-conditioning system according to claim 3 or 4,
wherein the plurality of interior units are disposed so as to correspond to respective racks out of the plurality of racks aligned in the lateral direction.

6. The air-conditioning system according to claim 5,
further comprising a plurality of partition members which partition the hot area formed along the rack row at positions respectively corresponding to the plurality of racks that are aligned in the lateral direction and which obstruct the dispersion of hot air.

7. The air-conditioning system according to any of claim 3 to 6,
wherein at least one out of the plurality of interior units includes a plurality of interior sub units disposed in the up-down direction, and
at least one of the plurality of exterior units includes a plurality of exterior sub units connected to respective units out of the plurality of interior sub units via separate piping systems.

8. The air-conditioning system according to claim 7,
wherein the interior heat exchanging system includes a plurality of interior sub units disposed in a matrix.

9. The air-conditioning system according to claim 7 or 8,
wherein the supplying fan includes a plurality of fan units that blow out cold air toward different positions in the up-down direction of one or more racks out of the plurality of racks.

10. The air-conditioning system according to any of claim 1 to 9,
wherein the interior heat exchanging system forms the cold air buffer area that is narrow at the top and wide at the bottom.

11. A room unit comprising:
the air-conditioning system according to any of claim 1 to 10;
a rack row where a plurality of racks are aligned in the lateral direction;
a double floor on which the rack row is installed; and
a housing that stores the rack row and the interior heat exchanging system of the air-conditioning system.

12. The room unit according to claim 11:
wherein the plurality of racks include server racks for holding servers in the up-down direction.
